# DEMANDE DE BREVET EUROPEEN

(11) **EP 4 350 761 A1**
(43) Date de publication de la demande: **10.04.2024**
(21) Numéro de dépôt: 23199008.6
(22) Date de dépôt: 22.09.2023
(51) Int. Cl.: H01L 23/48

(54) **PUCE ELECTRONIQUE COMPORTANT UNE METALLISATION DE TYPE UBM**

(30) Priorité: 03.10.2022 FR 2210096
(71) Demandeur: Commissariat à l'énergie atomique et aux énergies alternatives, 75015 Paris (FR)
(72) Inventeur: LOBRE, Clément, 38054 GRENOBLE CEDEX 9 (FR); SERRES, Eva, 38054 GRENOBLE CEDEX 9 (FR); DUPRE, Ludovic, 38054 GRENOBLE CEDEX 9 (FR)
(74) Mandataire: Cabinet Beaumont

(57) **Abrégé**

La présente description concerne une puce électronique (11) comportant un substrat (15) et, du côté d'une face du substrat, un plot métallique (13) destiné à recevoir un matériau de brasure (14), le plot comportant, dans l'ordre à partir de ladite face du substrat, une première couche métallique (21), une couche barrière électriquement conductrice (23) et une deuxième couche métallique (25), dans laquelle une couche barrière électriquement isolante (27) est disposée sur et en contact avec le flanc de la première couche métallique (21) sur toute la périphérie du plot métallique (13).

## Description

### Domaine technique

La présente description concerne de façon générale le domaine des puces électroniques et, plus particulièrement, le domaine de l'assemblage et de la connexion électrique d'une puce électronique à un dispositif électronique externe.

### Technique antérieure

L'assemblage et la connexion d'une puce électronique à un dispositif externe à la puce peut être réalisé par brasure, c'est-à-dire par dépôt d'une bille de connexion en un matériau de brasure électriquement conducteur à l'interface entre un contact métallique de la puce et un contact métallique correspondant du dispositif externe. Côté puce, le contact métallique comprend généralement une métallisation sous bosse ou UBM (de l'anglais "Under Bump Metallization") comportant plusieurs couches qui assurent une bonne ohmicité du contact, un rôle de barrière à la diffusion métallique dans le contact, et une bonne adhésion de la bille de connexion au contact.

Il existe un besoin d'améliorer au moins en partie certains aspects des puces électroniques comportant des métallisations de type UBM et de leurs procédés de fabrication.

### Résumé de l'invention

Un mode de réalisation prévoit une puce électronique comportant un substrat et, du côté d'une face du substrat, un plot métallique destiné à recevoir un matériau de brasure, le plot comportant, dans l'ordre à partir de ladite face du substrat, une première couche métallique, une couche barrière électriquement conductrice et une deuxième couche métallique, dans laquelle une couche barrière électriquement isolante est disposée sur et en contact avec le flanc de la première couche métallique sur toute la périphérie du plot métallique.

Selon un mode de réalisation, la couche barrière électriquement isolante est disposée sur et en contact avec au moins une partie du flanc de la couche barrière électriquement conductrice.

Selon un mode de réalisation, le matériau de brasure comprend de l'indium.

Selon un mode de réalisation, les première et deuxième couches métalliques sont en or.

Selon un mode de réalisation, la couche barrière électriquement isolante est en sulfure de zinc ou en dioxyde de silicium.

Selon un mode de réalisation, le substrat est en un alliage à base de cadmium de mercure et de tellurure.

Un autre mode de réalisation prévoit un procédé de fabrication d'une puce électronique comportant les étapes successives suivantes :
a) sur un substrat, déposer successivement une première couche métallique, une couche barrière électriquement conductrice et une deuxième couche métallique ;
b) graver la première couche métallique, la couche barrière électriquement conductrice et la deuxième couche métallique de façon à définir un plot métallique au moyen d'une étape de photolithographie unique ; et
c) former une couche barrière électriquement isolante sur et en contact avec le flanc de la première couche métallique sur toute la périphérie du plot métallique.

Selon un mode de réalisation, le procédé comporte, avant l'étape a), une étape de dépôt d'une couche de passivation sur la face supérieure du substrat et dans lequel la couche barrière électriquement isolante de l'étape c) est formée par prolongement de la gravure de l'étape b) dans la couche de passivation et re-dépôt du matériau de gravure sur les flancs du plot métallique.

Selon un mode de réalisation, l'étape c) comprend une étape de dépôt d'un matériau isolant sur toute la surface de la puce et une étape de gravure unidirectionnelle de façon à conserver ledit matériau isolant uniquement sur les flancs du plot métallique pour former la couche barrière électriquement isolante.

Selon un mode de réalisation, l'étape c) comprend le dépôt d'un matériau isolant sur toute la surface de la puce électrique, après dépôt d'une couche sacrificielle sur la face supérieure du plot métallique, puis le retrait de la couche sacrificielle pour exposer la face supérieure du plot métallique et conserver le matériau isolant sur les flancs du plot métallique de façon à former la couche barrière.

Selon un mode de réalisation, l'étape c) comprend une étape de dépôt d'un matériau isolant sur toute la surface de la puce électrique de façon à recouvrir le plot métallique et la face supérieure du substrat, suivie d'une étape de planarisation destinée à découvrir la face supérieure du plot métallique.

Selon un mode de réalisation, l'étape c) comprend une étape de dépôt d'un matériau isolant sur toute la surface de la puce électrique, une étape de dépôt d'une couche sacrificielle sur toute la surface de la puce électrique, une étape de gravure plasma de toute la surface de la puce électrique de façon à dévoiler la face supérieure du matériau isolant en vis-à-vis du plot métallique, une étape de gravure ionique de toute la surface de la puce électrique de façon à dévoiler la face supérieure du plot métallique et enfin une étape de retrait de ce qui subsiste de la couche sacrificielle par gravure humide.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'une puce électronique comportant une métallisation de type UBM ;
la figure 2 est une vue en coupe, partielle et schématique, d'une puce électronique comportant une métallisation de type UBM selon un mode de réalisation ;
la figure 3 illustre un premier exemple de réalisation d'une puce électronique du type décrit en relation avec la figure 2 ;
la figure 4 illustre un deuxième exemple de réalisation d'une puce électronique du type décrit en relation avec la figure 2 ;
la figure 5A et la figure 5B illustrent des étapes successives d'un procédé de formation d'un troisième exemple de réalisation d'une puce électronique du type décrit en relation avec la figure 2 ;
la figure 6A et la figure 6B illustrent des étapes successives d'un procédé de formation d'un quatrième exemple de réalisation d'une puce électronique du type décrit en relation avec la figure 2 ; et
la figure 7A, la figure 7B et la figure 7C illustrent des étapes successives d'un procédé de formation d'un cinquième exemple de réalisation d'une puce électronique du type décrit en relation avec la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, seule la réalisation d'une métallisation de type UBM d'une puce électronique a été détaillée. La réalisation des autres éléments de la puce et notamment des circuits intégrés et des composants électroniques présents dans la puce n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

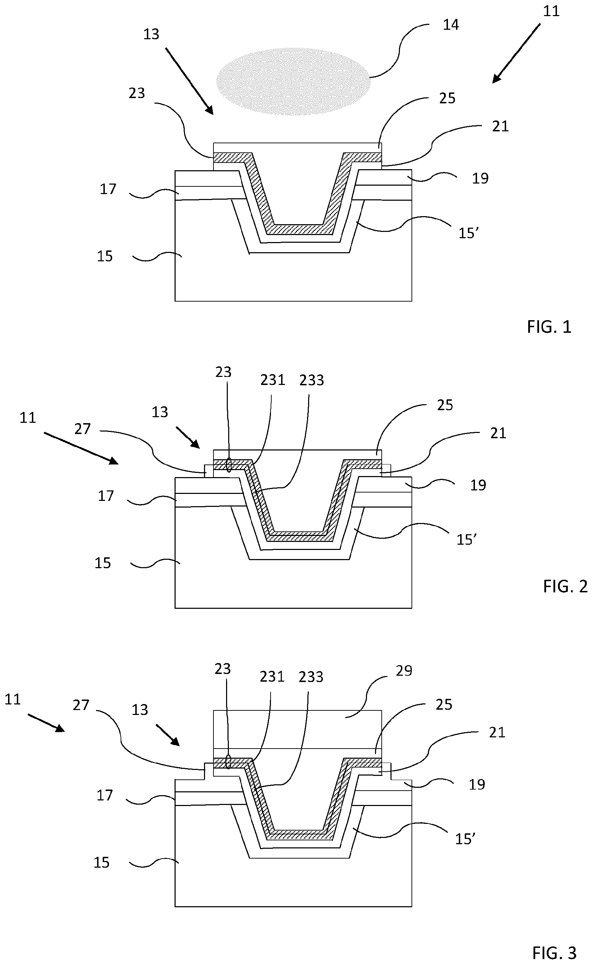

La figure 1 est une vue en coupe, partielle et schématique, d'un exemple d'une puce électronique 11 comportant une métallisation de type UBM 13 aussi appelée plot métallique.

La puce électronique 11 comprend par exemple une photodiode, par exemple une photodiode infrarouge. La puce est par exemple destinée à être associée à un système de refroidissement, par exemple cryogénique, visant à limiter le bruit thermique parasite mesuré par la photodiode.

Afin d'être assemblée et connectée électriquement à un autre dispositif électronique, la puce 11 peut recevoir, sur et en contact avec la face supérieure du plot métallique 13, un matériau de brasure 14, par exemple sous la forme d'une bille de connexion.

Le matériau de brasure 14 est par exemple de l'indium (In) ou un alliage à base d'indium. Les matériaux de brasure à base d'indium ont en effet de bonnes propriétés de conductivité électrique et de tenue mécanique dans une large gamme de températures et notamment à des températures cryogéniques.

La puce électronique 11 comporte un substrat semiconducteur 15, sur lequel le plot métallique 13 est formé.

A titre d'exemple, le plot métallique 13 est en contact, par sa face inférieure, avec la face supérieure du substrat 15.

Le substrat 15 est par exemple en un matériau semiconducteur, par exemple en un alliage de cadmium (Cd) de mercure (Hg) et de tellurure (Te) dit CMT. Le substrat 15 est par exemple dopé, par exemple d'un premier type de conductivité, par exemple de type N, par exemple dopé d'atomes d'indium. A titre d'exemple, à l'interface avec le plot métallique 13, le substrat 15 est dopé d'un deuxième type de conductivité, par exemple de type P, par exemple dopé d'atomes d'arsenic ou d'antimoine, de façon à former une région 15'.

A titre d'exemple, le substrat 15 est surmonté d'au moins une couche de passivation. Le substrat 15 est, par exemple surmonté de deux couches de passivation 17 et 19. Dans l'exemple représenté, une partie inférieure du plot métallique 13 est disposée dans une cavité traversant verticalement les couches de passivation 17 et 19 est débouchant sur le substrat 15. Plus particulièrement, dans cet exemple, la cavité se prolonge à travers une partie de l'épaisseur du substrat 15. Ainsi, le plot métallique 13 s'étend partiellement dans le substrat 15. A titre d'exemple, les couches de passivation 17 et 19 sont isolantes électriquement. La couche 17 est, par exemple située sur et en contact avec le substrat 15 et, est, par exemple en un matériau semiconducteur non dopé, par exemple en un matériau semiconducteur présentant une largeur de bande interdite supérieure à celle du matériau du substrat 15, par exemple en tellure et cadmium (CdTe). La couche 19 est par exemple située sur et en contact avec la couche 17 et est par exemple en un matériau diélectrique, par exemple en sulfure de zinc (ZnS), oxyde de silicium (SiOx) et/ou en nitrure de silicium (SiN).

Le plot métallique 13 correspond dans cet exemple à un empilement de trois couches, une première couche métallique 21, une couche barrière électriquement conductrice 23, et une deuxième couche métallique 25. A titre d'exemple, la couche 21 est disposée sur et en contact avec la face supérieure du substrat 15, la couche 23 est disposée sur et en contact avec la face supérieure de la couche 21 et la couche 25 est disposée sur et en contact avec la face supérieure de la couche 23. Dans cet exemple, le matériau de brasure 14 est destiné à être mis en contact avec la face supérieure de la couche 25.

La couche métallique 21 est par exemple en or (Au) qui présente l'avantage de permettre un bon contact ohmique avec la région 15' dopée P du substrat CMT 15.

La couche 25 est par exemple également en or (Au), qui présente l'avantage de permettre une bonne adhésion des matériaux de brasure à base d'indium.

La couche barrière 23 est, dans cet exemple, adaptée à empêcher la diffusion de l'indium du matériau de brasure 14 dans le plot métallique. En effet, en pratique, l'indium réagit facilement avec l'or pour former un alliage intermétallique or-indium, plus volumineux que l'or. La couche barrière 23 a pour rôle de bloquer la diffusion de l'indium et d'empêcher des migrations d'indium vers la face inférieure du plot métallique 13 et notamment vers le substrat 15. En effet, la migration de l'indium vers la face inférieure du plot métallique 13 engendre un risque pour l'intégrité mécanique du plot métallique 13 du fait de la formation de l'alliage intermétallique dans la couche 21. A titre d'exemple, la couche barrière 23 comprend un empilement d'une ou plusieurs couches électriquement conductrice, par exemple un empilement d'une couche de titane (Ti) et d'une couche de platine (Pt) ou un empilement d'une couche de chrome (Cr) et d'une couche de platine.

A titre d'exemple, le plot métallique 13 a, en vue de dessus, une forme ronde ou carrée. Les modes de réalisation décrits ne se limitent toutefois pas à ce cas particulier.

Dans cet exemple, les couche 21, 23 et 25 s'étendent sur la face supérieure de la couche de passivation 19 dans une partie périphérique du plot métallique 13.

A titre d'exemple, les couches 21, 23 et 25 sont d'abord successivement déposées sur toute la surface supérieure de la puce, puis gravées, par exemple au moyen d'une étape de photolithographie unique, pour former le plot 13. Il en résulte que les flancs des couches 21, 23 et 25 du plot 13 sont alignés verticalement comme l'illustre la figure.

Une limitation de la structure de la figure 1 est que les flancs des couches 21, 23 et 25 sont exposés. Ainsi, lors de l'assemblage, une partie du matériau de brasure 14 est susceptible de recouvrir les flancs du plot et en particulier d'entrer en contact avec les flancs de la couche d'or inférieure 21. Dans ce cas, l'indium du matériau de brasure peut entraîner la formation de l'alliage or-indium dans toute ou partie de la couche 21,conduisant à dégrader la puce.

Une possibilité pour pallier cette limitation est de mettre en oeuvre deux étapes de photolithographie distinctes pour réaliser le plot métallique 13. A titre d'exemple, la couche d'or inférieure 21 est d'abord déposée puis gravée au moyen d'une première étape de photolithographie. Les couches 23 et 25 sont ensuite déposées puis gravée au moyen d'une deuxième étape de photolithographie. Lors de la deuxième étape de photolithographie, la partie masquée présente une surface supérieure à la partie masquée lors de la première étape, de sorte que la couche barrière 23 et la couche d'or supérieure 25 recouvrent les flancs de la couche d'or inférieure 21, prévenant tout risque de contact entre la couche d'or inférieure 21 et le matériau de brasure 14. En plus du coût engendré par la double photolithographie, un alignement précis des deux photolithographies est nécessaire. La réduction des dimensions des puces rend cet alignement problématique.

La figure 2 est une vue en coupe, partielle et schématique, d'une puce électronique comportant une métallisation de type UBM ou plot de contact métallique 13 selon un mode de réalisation.

Le plot de contact métallique 13 illustré en figure 2 est similaire au plot de contact métallique 13 illustré en figure 1 à la différence près que, dans l'exemple de la figure 2, une couche barrière électriquement isolante 27 aussi appelée barrière isolante est disposée sur et en contact avec le flanc de la couche d'or inférieure 21 sur toute la périphérie du plot métallique 13.

La barrière isolante 27 est disposée sur toute la hauteur du flanc de la couche 21 de sorte que le flanc de la couche 21 soit recouvert intégralement par la barrière isolante 27. A titre d'exemple, la barrière isolante 27 a une hauteur supérieure ou égale à l'épaisseur de la couche 21, c'est à dire à la hauteur du flanc de la couche 21.

A titre d'exemple, la barrière isolante 27 a une hauteur supérieure à l'épaisseur de la couche 21, elle recouvre alors toute ou partie de la hauteur des flancs de la couche 23 et de la couche 25.

A titre d'exemple, la couche barrière 23 comprend un empilement de deux couches 231 et 233 en des matériaux électriquement conducteurs différents. A titre d'exemple, la couche 231 est située sur et en contact avec la face supérieure de la couche métallique 21, et la couche 233 est située sur et en contact avec la face supérieure de la couche 231. La couche 25 est par exemple située sur et en contact avec la face supérieure de la couche 233. La couche 231 est par exemple en titane (Ti) ou en chrome (Cr). La couche 233 est par exemple en platine (Pt). Plus généralement, la couche barrière 23 peut avoir toute autre structure ou composition adaptée à bloquer la diffusion de l'indium et la formation de l'alliage or-indium.

Un avantage de la puce de la figure 2 est que la barrière isolante 27 prévient tout risque de contact entre le matériau de brasure 14 et les flancs de la couche d'or inférieure 21.

La barrière isolante 27 peut être formée par différents procédés et ainsi avoir différentes formes. Des exemples de réalisation de la barrière isolante 27 sont décrits plus en détail ci-après.

La figure 3 est une vue en coupe illustrant plus en détail un exemple de réalisation d'une puce électronique du type décrit en relation avec la figure 2.

Plus particulièrement, dans l'exemple de la figure 3, la barrière isolante 27 correspond à une couche en le même matériau que la couche de passivation 19, formée par re-dépôt du matériau de la couche de passivation 19 lors d'une étape de gravure.

Après le dépôt des couches 17 et 19 sur le substrat 15, la formation de l'ouverture destinée à accueillir le plot métallique 13, et le dépôt des couches 21, 23 et 25 dans l'ouverture et sur la face supérieure de la couche 19, une étape de retrait localisé des couche 21, 23 et 25, par photolithographie et gravure, est mise en oeuvre, pour former le plot 13. Dans cet exemple, les couches 21, 23 et 25 sont retirées au moyen d'une étape de photolithographie unique. Pour cela, une couche de résine 29 est formée pleine plaque sur la face supérieure de la couche 25, puis exposée localement aux UV de façon à ce qu'elle puisse être conservée en vis-à-vis du plot 13 à former et retirée tout autour du plot 13. La structure ainsi obtenue est ensuite gravée de sorte à retirer les parties des couches 21, 23 et 25 non protégées par la résine 29. Il en résulte que les flancs des couches 21, 23 et 25 du plot sont alignés verticalement comme l'illustre la figure.

La gravure est, dans cet exemple, prolongée après retrait complet des couches 21, 23 et 25 en dehors du vis-à-vis de la résine 29, de façon à graver une partie de l'épaisseur la couche 19. Cette poursuite de gravure engendre un re dépôt du matériau de la couche 19, par exemple du ZnS, sur et en contact avec les flancs du plot 13 et en particulier sur les flancs de la couche d'or inférieure 21. A titre d'exemple, la gravure mise en oeuvre lors de cette étape est une gravure ionique.

La largeur de la barrière isolante 27 et sa hauteur sont, par exemple dictées par la topologie du plot métallique 13, l'angle de gravure et l'épaisseur de gravure de la couche 19. L'angle de gravure est par exemple de 0° par rapport à la normale à la face supérieure du substrat. A titre d'exemple, pour une topologie (épaisseur cumulée des couches 21, 23, 25 et 29 au-dessus de la face supérieure de la couche de passivation 19) de l'ordre de 1,5 µm, un angle de gravure de l'ordre de 0° et une épaisseur de gravure de la couche 19 de l'ordre de 300 nm, on obtient par exemple une barrière isolante 27 d'épaisseur de l'ordre de 25 nm sur les flancs de la couche 21 et sur au moins une partie inférieure des flancs de la couche barrière 23.

Un avantage du mode de réalisation de la figure 3 est que le plot métallique 13 peut être formé au moyen d'une étape de photolithographie unique. En outre, la barrière isolante 27 est formée sur les flancs du plot métallique 13 sans qu'une étape supplémentaire soit ajoutée dans le procédé de fabrication des puces électroniques.

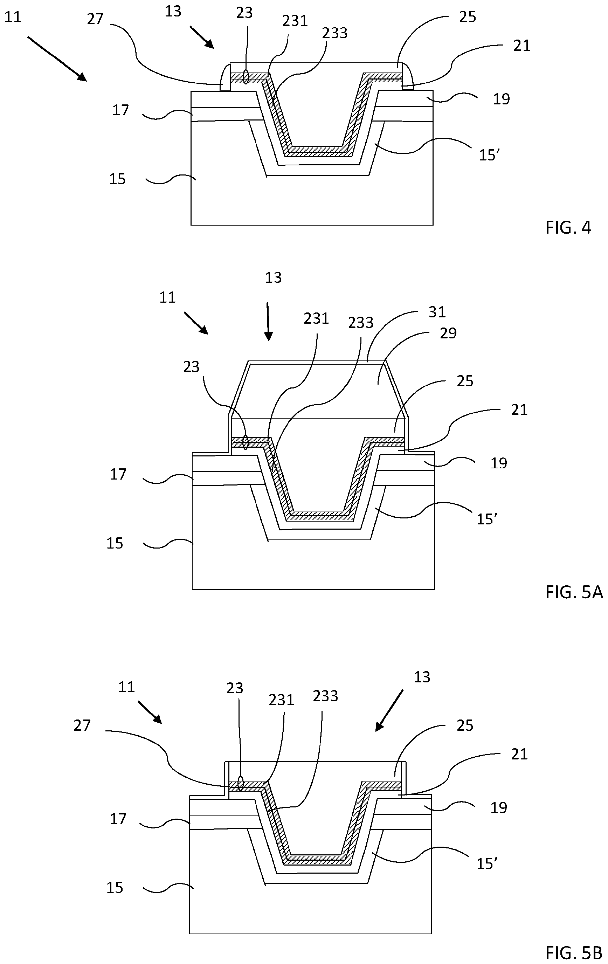

La figure 4 est une vue en coupe illustrant plus en détail un autre exemple de réalisation d'une puce électronique du type décrit en relation avec la figure 2.

Dans l'exemple de la figure 4, la barrière isolante 27 correspond à un espaceur situé sur les flancs de la couche 21, l'espaceur étant formé par gravure unidirectionnelle d'un matériau isolant déposé après la formation du plot 13.

Le plot métallique 13 est par exemple réalisé par photolithographie et gravure tel que décrit ci-dessus en relation avec la figure 3. Dans l'exemple de la figure 4, la gravure n'est pas prolongée dans la couche 19.

Après retrait de la résine de masquage 29, on vient, dans cet exemple, déposer pleine plaque une couche en un matériau isolant, par exemple diélectrique, par exemple du sulfure de zinc ou du dioxyde de silicium. Le matériau isolant recouvre en particulier la face supérieure et les flancs du plots métallique 13, ainsi que la face supérieure de la couche de passivation 19. A titre d'exemple, le matériau isolant est déposé par un procédé de dépôt conforme. A titre d'exemple, la couche en le matériau isolant à une épaisseur comprise entre 10 nm et 150 nm, par exemple de l'ordre de 50 nm.

La couche en le matériau isolant est ensuite gravée par un procédé de gravure anisotrope verticale, par exemple par gravure ionique unidirectionnelle avec un angle nul par rapport à la normale de la face supérieure de la structure, jusqu'à découvrir la face supérieure du plot métallique 13 et la face supérieure de la couche de passivation 19 autour du plot 13. Le matériau isolant est en revanche préservé sur les flancs du plot métallique 13, formant la barrière isolante 27.

La figure 5A et la figure 5B sont des vues en coupe illustrant des étapes d'un autre exemple de procédé de réalisation d'une puce électronique du type décrit en relation avec la figure 2.

Dans l'exemple des figures 5A et 5B, la barrière isolante 27 correspond à une couche située sur les flancs de la couche 21 et localisée au moyen d'une couche de résine sacrificielle.

Le plot métallique 13 est par exemple réalisé par photolithographie et gravure tel que décrit ci-dessus en relation avec la figure 3. Dans l'exemple des figures 5A et 5B, la gravure n'est pas prolongée dans la couche 19.

Dans cet exemple, la résine de masquage 29 est conservée sur la face supérieure du plot métallique 13 à l'issue de la gravure. On vient ensuite déposer une couche 31 en un matériau isolant, par exemple de façon conforme, par exemple pleine plaque. Dans cet exemple, la couche 31 s'étend sur et en contact avec la face supérieure et les flancs de la couche de résine 29, les flancs du plot métallique 13, et la face supérieure de la couche 19. La figure 5A illustre la structure obtenue à l'issue de cette étape de dépôt. A titre d'exemple, la couche 31 à une épaisseur comprise entre 10 nm et 100 nm, par exemple de l'ordre de 50 nm.

A titre d'exemple, la couche 31 est en un matériau diélectrique, par exemple en sulfure de zinc ou en dioxyde de silicium.

L'étape de dépôt de la couche 31 est suivie d'une étape dite de décollement ("lift-off" en anglais). Lors de cette étape, la couche de résine 29 est retirée avec les parties de la couche 31 qui la recouvrent et seules les parties de la couche 31 situées sur les flancs de l'UBM 13 et sur la face supérieure de la couche 19 sont conservées de façon à former la barrière isolante 27. A titre d'exemple, cette étape de décollement est réalisée par lavage de la structure par un solvant. La figure 5B illustre la structure obtenue à l'issue de cette étape.

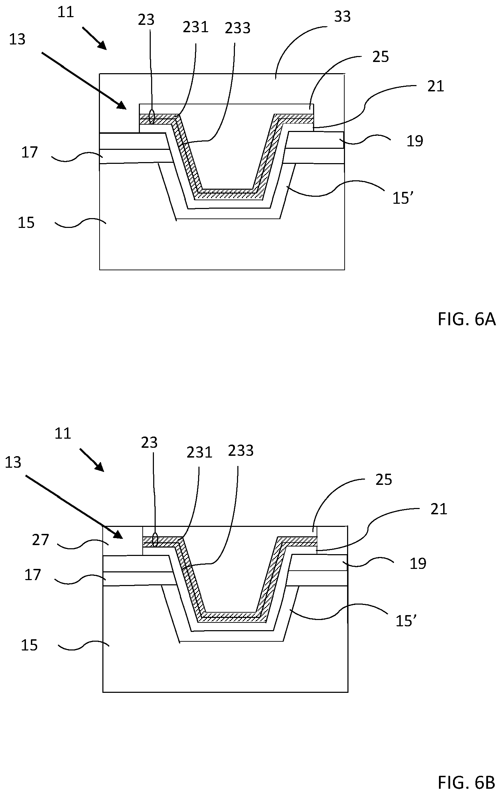

La figure 6A et la figure 6B sont des vues en coupe illustrant des étapes d'un autre exemple de procédé de réalisation d'une puce électronique du type décrit en relation avec la figure 2.

Dans cet exemple, la barrière isolante 27 correspond à une couche affleurant la face supérieure de la couche 21 et comblant l'espace libre autour du plot métallique 13.

Le plot métallique 13 est par exemple réalisé par photolithographie et gravure tel que décrit ci-dessus en relation avec la figure 3. Dans l'exemple des figures 6A et 6B, la gravure n'est pas prolongée dans la couche 19.

Après retrait de la résine de masquage 29, la barrière isolante 27 est dans cet exemple formée par dépôt d'une couche isolante 33, pleine plaque, c'est-à-dire sur et en contact avec la face supérieure de la couche 19, la face supérieure de l'UBM 13 et les flancs de l'UBM 13. La couche isolante 33 est par exemple en un matériau diélectrique, par exemple en sulfure de zinc ou en dioxyde de silicium.

Dans cet exemple, la couche 33 est formée avec une épaisseur supérieure à l'épaisseur du plot métallique 13, c'est-à-dire l'épaisseur cumulée de la couche 21, de la couche 23 et de la couche 25, au-dessus de la couche de passivation 19. Ainsi, l'UBM 13 est intégralement recouvert par la couche 33 comme cela est illustré en figure 6A. A titre d'exemple, la couche 33 a une épaisseur supérieure à 600 nm. La couche 33 a par exemple une face supérieure sensiblement plane.

A la suite de l'étape de dépôt de la couche 33, la structure est planarisée ou amincie, par exemple par une planarisation mécano-chimique. La planarisation est, par exemple arrêtée lorsque la face supérieure du plot métallique 13 est dévoilée. A l'issue de cette étape, la face supérieure du plot métallique 13 affleure la face supérieure de la couche 33 formant la barrière isolante 27 comme cela a été illustré en figure 6B.

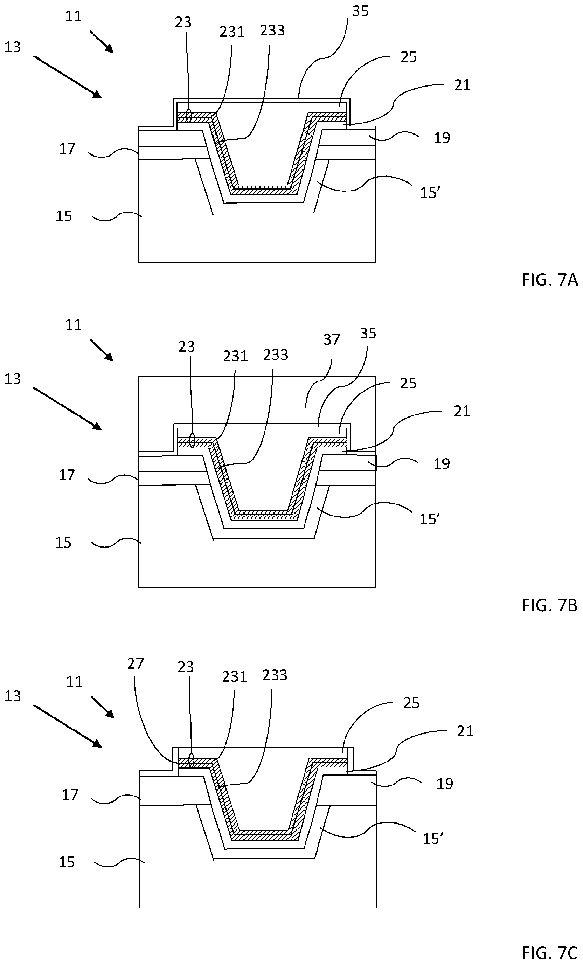

La figure 7A, la figure 7B et la figure 7C sont des vues en coupe illustrant des étapes d'un autre exemple de procédé de réalisation d'une puce électronique du type décrit en relation avec la figure 2.

Le plot métallique 13 est par exemple réalisé par photolithographie et gravure tel que décrit ci-dessus en relation avec la figure 3. Dans l'exemple des figures 7A, 7B et 7C, la gravure n'est pas prolongée dans la couche 19.

Apres retrait de la couche de résine de masquage 29, on vient, dans cet exemple, déposer une couche isolante 35, par exemple de façon conforme, par exemple pleine plaque. La couche 35 est en particulier déposée sur et en contact avec la face supérieure de la couche 19, et sur et en contact avec la face supérieure et les flancs du plot métallique 13 de façon à former la structure illustrée en figure 7A. A titre d'exemple, la couche isolante 35 est en un matériau diélectrique, par exemple en sulfure de zinc ou en dioxyde de silicium. A titre d'exemple, la couche 35 à une épaisseur comprise entre 50 et 500 nm, par exemple de l'ordre de 200 nm.

A la suite de cette étape de dépôt de la couche 35, on vient déposer une couche sacrificielle ou couche de planarisation 37 sur toute la surface de la couche 35 et, par exemple en contact avec celle-ci. La couche sacrificielle 37 est, par exemple une couche de résine. La couche 37 est par exemple déposée avec une épaisseur supérieure à l'épaisseur de l'UBM 13, de sorte que l'UBM soit intégralement recouvert par la couche 37 et ainsi former la structure illustrée en figure 7B. La couche 37 est, par exemple, déposée par centrifugation. A titre d'exemple, à l'issue de cette étape, la face supérieure de la couche 37 est plane.

A la suite des dépôts des couches 35 et 37, une étape de gravure est mise en oeuvre du côté de la face de la face supérieure de la structure, par exemple une gravure plasma. A titre d'exemple, la gravure présente une vitesse de gravure de la couche 37 supérieure à celle de la couche 35. Lors de cette étape, la couche 37 est amincie par sa face supérieure jusqu'à exposer la face supérieure de la portion de la couche 35 revêtant la face supérieure du plot métallique 13. A titre d'exemple, à l'issue de cette étape, le plot métallique 13 affleure au niveau de la face supérieure de la couche de résine 37. Ainsi, les parties de la couche 35 revêtant la face supérieure de la couche 19 et les flancs du plot 13 restent recouvertes par la couche de résine 37.

Une deuxième gravure, par exemple une gravure ionique, peut ensuite être mise en oeuvre pour retirer la partie de la couche 35 située sur la face supérieure du plot métallique 13. A titre d'exemple, la deuxième gravure est sélective et permet de s'arrêter dès que la face supérieure de la couche 25 est dévoilée.

Une gravure chimique supplémentaire, par exemple une gravure humide, peut ensuite être mise en oeuvre pour retirer la résine sacrificielle 37 autour du plot métallique 13 de façon à former la structure illustrée en figure 7C.

A ce stade, la couche diélectrique 35 revêt au moins une partie inférieure des flancs du plot métallique 13 et forme la couche barrière 27.

Un avantage des procédés décrits en relation avec les figures 3, 4, 5A, 5B, 6A, 6B, 7A, 7B, 7C est qu'ils permettent de réaliser le plot métallique 13 et la barrière isolante 27 au moyen d'une unique étape de photolithographie.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisations décrits ne se limitent pas aux exemples de dimensions et de matériaux mentionnés ci-dessus.

En particulier, bien que l'on ait décrit ci-dessus un exemple particulier d'application à des plots métalliques à base d'or destinés à recevoir un matériau de brasure à base d'indium, les modes de réalisation décrits ne se limitent pas à ce cas particulier. Plus généralement, la personne du métier saura adapter les modes de réalisation décrits à tout empilement métallique de type UBM comportant au moins une couche métallique inférieure, une couche barrière, et une couche métallique supérieure destinée à recevoir un matériau de brasure, dans lequel il est souhaitable d'éviter un contact entre le matériau de brasure et la couche métallique inférieure.

De plus, bien que les modes de réalisation aient été décrits pour des puces comportant des photodiodes infrarouges, ils peuvent être aisément adaptés à d'autres types de puce.

Enfin, la mise en oeuvre pratique des modes de réalisation et variantes décrits est à la portée de la personne du métier à partir des indications fonctionnelles données ci-dessus.

## Revendications

1. Puce électronique (11) comportant un substrat semiconducteur (15) et, du côté d'une face du substrat, un plot métallique (13) destiné à recevoir un matériau de brasure (14), le plot comportant, dans l'ordre à partir de ladite face du substrat, une première couche métallique (21) sur et en contact avec ladite face du substrat, une couche barrière électriquement conductrice (23) sur et en contact avec ladite première couche métallique, et une deuxième couche métallique (25) sur et en contact avec ladite couche barrière électriquement conductrice, dans laquelle les flancs de la première couche métallique (21), de la couche barrière électriquement conductrice (23) et de la deuxième couche métallique (25) sont alignés verticalement, et dans laquelle une couche barrière électriquement isolante (27) est disposée sur et en contact avec le flanc de la première couche métallique (21) sur toute la périphérie du plot métallique (13).

2. Puce selon la revendication 1, dans laquelle la couche barrière électriquement isolante (27) est disposée sur et en contact avec au moins une partie du flanc de la couche barrière électriquement conductrice (23).

3. Puce selon la revendication 1 ou 2, dans laquelle le matériau de brasure (14) comprend de l'indium.

4. Puce selon l'une quelconque des revendications 1 à 3, dans laquelle les première (21) et deuxième (25) couches métalliques sont en or.

5. Puce selon l'une quelconque des revendications 1 à 4, dans laquelle la couche barrière électriquement isolante (27) est en sulfure de zinc ou en dioxyde de silicium.

6. Puce selon l'une quelconque des revendications 1 à 5, dans laquelle le substrat (15) est en un alliage à base de cadmium de mercure et de tellurure.

7. Procédé de fabrication d'une puce électronique (11) selon l'une quelconque des revendications 1 à 6, comportant les étapes successives suivantes :
a) sur une face d'un substrat semiconducteur (15), déposer successivement une première couche métallique (21) sur et en contact avec ladite face du substrat, une couche barrière électriquement conductrice (23) sur et en contact avec ladite première couche métallique, et une deuxième couche métallique (25) sur et en contact avec ladite couche barrière électriquement conductrice (23) ;
b) graver la première couche métallique (21), la couche barrière électriquement conductrice (23) et la deuxième couche métallique (25) de façon à définir un plot métallique (13) au moyen d'une étape de photolithographie unique ; et
c) former une couche barrière électriquement isolante (27) sur et en contact avec le flanc de la première couche métallique (21) sur toute la périphérie du plot métallique (13) .

8. Procédé selon la revendication 7, comportant, avant l'étape a), une étape de dépôt d'une couche de passivation (19) sur la face supérieure du substrat (15) et dans lequel la couche barrière électriquement isolante (27) de l'étape c) est formée par prolongement de la gravure de l'étape b) dans la couche de passivation (19) et re-dépôt du matériau de gravure sur les flancs du plot métallique (13).

9. Procédé selon la revendication 7, dans lequel l'étape c) comprend une étape de dépôt d'un matériau isolant sur toute la surface de la puce et une étape de gravure unidirectionnelle de façon à conserver ledit matériau isolant uniquement sur les flancs du plot métallique (13) pour former la couche barrière électriquement isolante (27).

10. Procédé selon la revendication 6, dans lequel l'étape c) comprend le dépôt d'un matériau isolant (31) sur toute la surface de la puce électrique (11), après dépôt d'une couche sacrificielle sur la face supérieure du plot métallique (13), puis le retrait de la couche sacrificielle pour exposer la face supérieure du plot métallique (13) et conserver le matériau isolant sur les flancs du plot métallique (13) de façon à former la couche barrière (27).

11. Procédé selon la revendication 7, dans lequel l'étape c) comprend une étape de dépôt d'un matériau isolant (33) sur toute la surface de la puce électrique (11) de façon à recouvrir le plot métallique (13) et la face supérieure du substrat (15), suivie d'une étape de planarisation destinée à découvrir la face supérieure du plot métallique (15).

12. Procédé selon la revendication 7, dans lequel l'étape c) comprend une étape de dépôt d'un matériau isolant (35) sur toute la surface de la puce électrique (11), une étape de dépôt d'une couche sacrificielle (37) sur toute la surface de la puce électrique (11), une étape de gravure plasma de toute la surface de la puce électrique (11) de façon à dévoiler la face supérieure du matériau isolant (35) en vis-à-vis du plot métallique (13), une étape de gravure ionique de toute la surface de la puce électrique (11) de façon à dévoiler la face supérieure du plot métallique (13) et enfin une étape de retrait de ce qui subsiste de la couche sacrificielle (37) par gravure humide.
